(19) Europäisches Patentamt
European Patent Office
Office européen des brevets

(11) **EP 3 792 786 A1**

(12) **EUROPEAN PATENT APPLICATION**
published in accordance with Art. 153(4) EPC

(43) Date of publication:
**17.03.2021 Bulletin 2021/11**

(51) Int Cl.:
***G06F 17/10*** (2006.01)

(21) Application number: **18917806.4**

(22) Date of filing: **08.05.2018**

(86) International application number:
**PCT/JP2018/017752**

(87) International publication number:
**WO 2019/215810 (14.11.2019 Gazette 2019/46)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Hitachi, Ltd.**
**Tokyo 100-8280 (JP)**

(72) Inventors:
• **TOBE, Sumito**
**Tokyo 100-8280 (JP)**
• **INAGE, Shinichi**
**Tokyo 100-8280 (JP)**
• **AKATSU, Tooru**
**Tokyo 100-8280 (JP)**
• **HARA, Kouichi**
**Tokyo 100-8280 (JP)**

(74) Representative: **MERH-IP Matias Erny Reichl Hoffmann**
**Patentanwälte PartG mbB**
**Paul-Heyse-Strasse 29**
**80336 München (DE)**

(54) **DATA ANALYSIS DEVICE, POWER FLOW ANALYSIS DEVICE, AND DATA ANALYSIS METHOD**

(57) On the basis of time-series data, a term-specific time-series data creation unit creates time-series data for each term that includes a derivative term; a linear sum generation unit generates, for each time point in the created time-series data, a raw value for the linear sum of the products of each term times a coefficient; a coefficient determination unit determines a coefficient for each term such that the total value of raw values for linear sums within the time interval or space interval covered by the time-series data is no greater than a set value, or approaches zero; and a governing equation output unit outputs, as a governing equation for the time-series data, the linear sum of the products of each coefficient determined by the coefficient determination unit times each term.

FIG. 1

$$e_i = \left[ \left(\frac{df}{dt}\right)_i + A_1 f\left(\frac{df}{dt}\right)_i + A_2 f^2\left(\frac{df}{dt}\right)_i + A_3 f^3\left(\frac{df}{dt}\right)_i + \cdots + A_m \left(\frac{d^2f}{dt^2}\right)_i + \cdots \right]^2$$

**Description**

Technical Field

The present invention relates to a data analysis device, a power flow analysis device and a data analysis method capable of acquiring a dominant equation from chronological data.

Background Art

Techniques to approximately represent chronological data as a function include a least square method that gives the function as a power sum of time and determines a coefficient of each power term of time to minimize an error between chronological data and the power sum of time. This technique can express chronological data as an approximate function. This technique can approximately represent chronological data as functions and has played a certain role in applications to analysis and control.

Citation List

Nonpatent Literature

Nonpatent Literature: Abdulrahman Baqais, Generic Algorithm for function approximation: An experimental investigation, International Journal of Artificial Intelligence and Applications (IJAIA), Vol. 7, No. 3, May 2016.

Summary of Invention

Technical Problem

However, the technique of giving the function as a power sum of time to express chronological data as a function evaluates chronological data as an approximate function or digital data. This technique was unable to find a dominant equation behind the chronological data.

The present invention has been made in consideration of the foregoing. It is an object of the invention to provide a data analysis device, a power flow analysis device, and a data analysis method capable of finding a dominant equation behind chronological data.

Solution to Problem

To achieve the above-mentioned object, the data analysis device according to the first aspect includes a term-based chronological data generation portion that, based on input chronological data, generates term-based chronological data including a differential term assumed to be a term of a dominant equation for the input chronological data; a linear sum generation portion that generates a positive value of the linear sum of products of each term and a coefficient at each time of the input chronological data; and a coefficient determination portion that determines the coefficient of each term so that the sum of positive values of the linear sum in one of a time segment and a space segment targeted by the chronological data becomes smaller than or equal to a predetermined value or approaches 0.

Advantageous Effects of Invention

The present invention can find a dominant equation behind chronological data.

Brief Description of Drawings

FIG. 1 is a block diagram illustrating a configuration of the data analysis device according to a first embodiment;
FIG. 2 is a block diagram illustrating a configuration of the data analysis device according to a second embodiment;
FIG. 3 is a block diagram illustrating a configuration of the data analysis device according to a third embodiment;
FIG. 4 is a block diagram illustrating a configuration of the data analysis device according to a fourth embodiment;
FIG. 5 is a block diagram illustrating a configuration of the power flow analysis device according to a fifth embodiment;
FIG. 6 is a block diagram illustrating a hardware configuration applicable to the data analysis device according to a sixth embodiment; and

FIG. 7 is a block diagram illustrating a configuration of the data analysis device according to a comparative example.

Description of Embodiments

Embodiments will be described with reference to the drawings. It should be noted that the embodiments described below do not limit the invention according to the claims. All the elements and combinations thereof described in the embodiments are not necessarily essential to means for solving the problems in the invention.

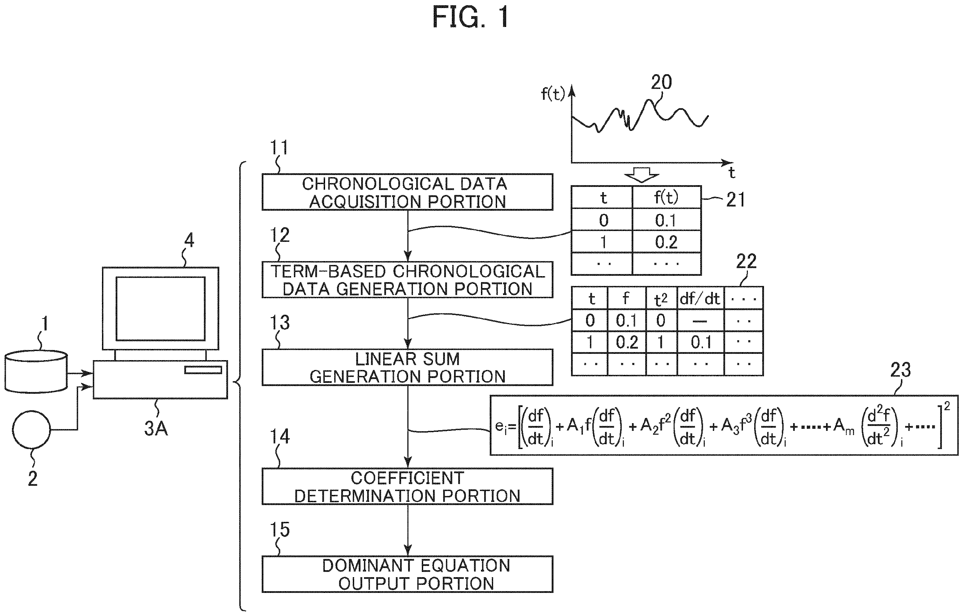

FIG. 1 is a block diagram illustrating a configuration of the data analysis device according to the first embodiment.

In FIG. 1, the data analysis device includes a terminal 3A. The terminal 3A is connected to a data storage medium 1, an external output portion 2, and a display portion 4. The terminal 3A includes a chronological data acquisition portion 11, a term-based chronological data generation portion 12, a linear sum generation portion 13, a coefficient determination portion 14, and a dominant equation output portion 15.

The chronological data acquisition portion 11 acquires chronological data 21. The chronological data 21 can be represented in digital data acquired by digitizing a waveform 20 represented by function f(t) at each time t. The chronological data acquisition portion 11 may acquire past measurement data as the chronological data 21 from the data storage medium 1 or may acquire real-time measurement data as the chronological data 21 from the external output portion 2.

Based on the chronological data 21, the term-based chronological data generation portion 12 generates term-based chronological data 22 including a differential term assumed to be a term of the dominant equation of chronological data 21. Terms of the chronological data 22 may include a differential term with respect to time or space; a power term of time, space, or physical quantity; a functional term of time, space, or physical quantity; or a product term found by multiplying terms. The linear sum generation portion 13 generates a positive value 23 of the linear sum of products of the respective terms and coefficients $A_1$ through $A_m$ (m is a positive integer) at each time t of the chronological data 22. The positive value 23 of the linear sum may be equal to a value resulting from squaring the linear sum or a value resulting from taking an absolute value of the linear sum. The coefficient determination portion 14 determines coefficients $A_1$ through $A_m$ of each term so that the sum of positive values 23 of the linear sum in a time segment or a space segment targeted by the chronological data 21 becomes smaller than or equal to a predetermined value or approaches 0. The dominant equation output portion 15 outputs the linear sum of products of coefficients $A_1$ through $A_m$, determined by the coefficient determination portion 14, and respective terms as a dominant equation of the chronological data 21.

The chronological data 21 acquired in the chronological data acquisition portion 11 is sent to the term-based chronological data generation portion 12. From the chronological data, the term-based chronological data generation portion 12 generates a primary or secondary differentiation with respect to the time, a power of the time, a power of the physical quantity, or the chronological data 22 for a product of the terms in tabular form.

For example, the term-based chronological data generation portion 12 can provide the following terms in advance.

(A1) Time-series linear function, quadratic function, cubic function, and quartic function
(A2) Exponential expressions f of function f such as $f^2$, $f^3$, ..., $f^{10}$
(A3) Exponential expressions x of point x such as $x^2$, $x^3$, ..., $x^{10}$
(A4) Functions of point x such as $\sin(Cx)$, $\cos(Cx)$, $e^{Cx}$, and so on
(A5) Product term resulting from multiplying terms in (A1) through (A4) above

A genetic algorithm can be used to settle C (constant) in (A4) and obtain an optimum value. In this case, it is possible to previously provide all terms that are assumed to be terms of the dominant equation for the chronological data 21. These terms can be maintained as a library in advance.

Suppose the following chronological data 21 is given to each time.

Time: $(t_0, t_1, t_2, t_3, ..., t_N)$
Chronological data: $(f_0, f_1, f_2, f_3, ..., f_N)$

N is an integer larger than or equal to 2. Given the time interval is $\Delta$, then (Equation 1) can give the primary differentiation and (Equation 2) can give the secondary differentiation at the i-th time.

[Equation 1]

$$\left(\frac{df}{dt}\right)_i = \frac{f_i - f_{i-1}}{\Delta}$$

[Equation 2]

$$\left(\frac{d^2 f}{dt^2}\right)_i = \frac{1}{\Delta}\left[\left(\frac{df}{dt}\right)_{i+1} - \left(\frac{df}{dt}\right)_i\right] = \frac{f_{i+1} + f_{i-1} - 2f_i}{\Delta^2}$$

Similarly, time interval $\Delta$ and data fi can be used to express the tertiary differentiation or higher orders.

Suppose the chronological data ($f_0$, $f_1$, $f_2$, $f_3$, ..., $f_N$) satisfies differential equations depending on the primary differentiation, the secondary differentiation, and so on. When the linear sum generation portion 13 is based on the primary differentiation, (Equation 3) below can then give the linear sum of products of terms of the chronological data 22 and coefficients $A_1$ through $A_m$.

[Equation 3]

$$\left(\frac{df}{dt}\right)_i + A_1\left(\frac{df}{dt}\right)_i + A_2 f\left(\frac{df}{dt}\right)_i + A_3 f^2\left(\frac{df}{dt}\right)_i + \cdots + A_m\left(\frac{d^2 f}{dt^2}\right)_i + \cdots = 0$$

For example, the linear sum generation portion 13 then squares the linear sum given by (Equation 3) to convert the linear sum into a positive value and calculates error ei. Error ei can be given by the following (Equation 4).

[Equation 4]

$$e_i = \left[\left(\frac{df}{dt}\right)_i + A_1 f\left(\frac{df}{dt}\right)_i + A_2 f^2\left(\frac{df}{dt}\right)_i + A_3 f^3\left(\frac{df}{dt}\right)_i + \cdots + A_m\left(\frac{d^2 f}{dt^2}\right)_i + \cdots\right]^2$$

The coefficient determination portion 14 calculates error E by calculating the total value of errors ei given by (Equation 4) through the times ($t_0$, $t_1$, $t_2$, $t_3$, ..., and $t_N$). The error E can be given by the following (Equation 5).

[Equation 5]

$$E = \sum_0^N e_i = \sum_0^N \left[\left(\frac{df}{dt}\right)_i + A_1 f\left(\frac{df}{dt}\right)_i + A_2 f^2\left(\frac{df}{dt}\right)_i + A_3 f^3\left(\frac{df}{dt}\right)_i + \cdots + A_m\left(\frac{d^2 f}{dt^2}\right)_i + \cdots\right]^2$$

Then, the coefficient determination portion 14 determines coefficients $A_1$ through $A_m$ for each term of error E so that error E given by (Equation 5) becomes smaller than or equal to the predetermined value or approaches 0. The dominant equation output portion 15 outputs, as a dominant equation of the chronological data 21, the linear sum of products of these coefficients $A_1$ through $A_m$ and the terms.

This makes it possible to find the dominant equation from the chronological data 21 and interpret the physical phenomenon represented by the chronological data 21. When the different chronological data 21 are obtained, it is possible to interpret whether the chronological data 21 reflect the same physical phenomenon or different physical phenomena. It is possible to easily determine the relevance between different chronological data 21.

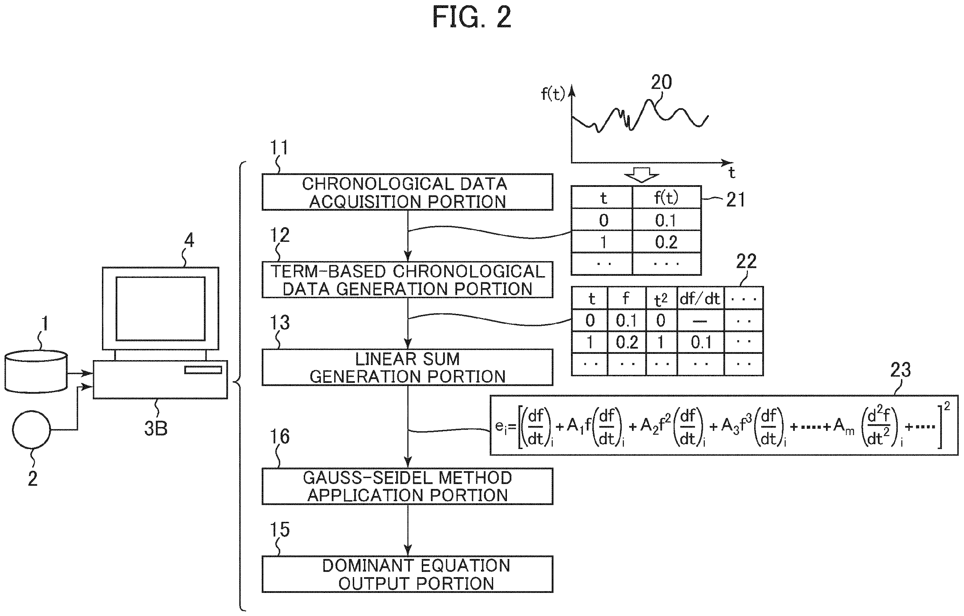

FIG. 2 is a block diagram illustrating a configuration of the data analysis device according to the second embodiment.

In the configuration of FIG. 2, a terminal 3B is provided instead of the terminal 3A in FIG. 1. The terminal 3B includes a Gauss-Seidel method application portion 16 as the coefficient determination portion 14 of FIG. 1. The Gauss-Seidel method application portion 16 numerically solves simultaneous equations based on the Gauss-Seidel method to determine coefficients $A_1$ through $A_m$ for the terms of error E in (Equation 5). Error E in (Equation 5), can be minimized by determining coefficients $A_1$ through $A_m$ to satisfy the following (Equation 6).

[Equation 6]

$$\left(\frac{\partial E}{\partial A_1}\right) = \left(\frac{\partial E}{\partial A_2}\right) = \left(\frac{\partial E}{\partial A_3}\right) \cdot \cdot \cdot = 0$$

In terms of coefficient $A_1$, for example, the following (Equation 7) and (Equation 8) can be found from (Equation 6).

[Equation 7]

$$\sum_0^N \left(\frac{df}{dt}\right)_i \left[\left(\frac{df}{dt}\right)_i + A_1 \left(\frac{df}{dt}\right)_i + A_2 f \left(\frac{df}{dt}\right)_i + A_3 f^2 \left(\frac{df}{dt}\right)_i + \cdots + A_m \left(\frac{d^2 f}{dt^2}\right)_i + \cdots \right] = 0$$

[Equation 8]

$$\left[\sum_0^N \left(\frac{df}{dt}\right)_i f \left(\frac{df}{dt}\right)_i\right] A_1 + \left[\sum_0^N \left(\frac{df}{dt}\right)_i f^2 \left(\frac{df}{dt}\right)_i\right] A_2 + \cdots = -\sum_0^N \left(\frac{df}{dt}\right)_i \left(\frac{df}{dt}\right)_i$$

A series of simultaneous linear equations for coefficients $A_1$ through $A_m$ can be found by similarly finding the equations in terms of coefficient $A_2$ and later. The solution of this simultaneous linear equation makes it possible to determine coefficients $A_1$ through $A_m$ minimizing error E in (Equation 5) and obtain a dominant equation behind the chronological data 21.

Generally, the nth-order simultaneous equations can be given by the following (Equation 9).

[Equation 9]

$$a_{ij} \cdot x_j = b_i$$

In this equation, aij is an n×n matrix. The coefficient to be obtained is $x_j$. The Gauss-Seidel method can be used to numerically solve (Equation 9). The Gauss-Seidel method is a convergent calculation and can be generally given by the following recurrence formula (Equation 10).

[Equation 10]

$$x_i^{(k+1)} = \frac{1}{a_{ii}}\left( b_i - \sum_{j=1}^{i-1} a_{ij}x_j^{(k+1)} - \sum_{j=i+1}^{n} a_{ij}x_j^{(k)} \right)$$

The following (Equation 11) can give a three-dimensional simultaneous equation as a simple example.

[Equation 11]

$$\begin{pmatrix} a_{11} & a_{12} & a_{13} \\ a_{21} & a_{22} & a_{23} \\ a_{31} & a_{32} & a_{33} \end{pmatrix} \begin{pmatrix} x_1 \\ x_2 \\ x_3 \end{pmatrix} = \begin{pmatrix} b_1 \\ b_2 \\ b_3 \end{pmatrix}$$

In this case, the following recurrence formulas (Equation 12), (Equation 13), and (Equation 14) can give $x_1$, $x_2$, and $x_3$.

[Equation 12]

$$x_1^{(k+1)} = (b_1 - a_{12}x_2^{(k)} - a_{13}x_3^{(k)})/a_{11}$$

[Equation 13]

$$x_2^{(k+1)} = (b_2 - a_{21}x_1^{(k+1)} - a_{23}x_3^{(k)})/a_{22}$$

[Equation 14]

$$x_3^{(k+1)} = (b_3 - a_{31}x_1^{(k+1)} - a_{32}x_2^{(k+1)})/a_{33}$$

In the convergence calculation, a tolerance is set to x(i+1) - x(i) < 10⁻⁶, for example. The calculation of (Equation 12), (Equation 13) and (Equation 14) can be repeated until the tolerance is satisfied.

The Gauss-Seidel method is used to calculate coefficients $A_1$ through $A_m$ for a dominant equation of the chronological data 21, making it possible to accurately find the dominant equation.

The above-described second embodiment has described the method of using the Gauss-Seidel method to calculate coefficients $A_1$ through $A_m$ has been described. However, coefficients $A_1$ through $A_m$ may be calculated by using a method of numerically solving simultaneous equations other than the Gauss-Seidel method.

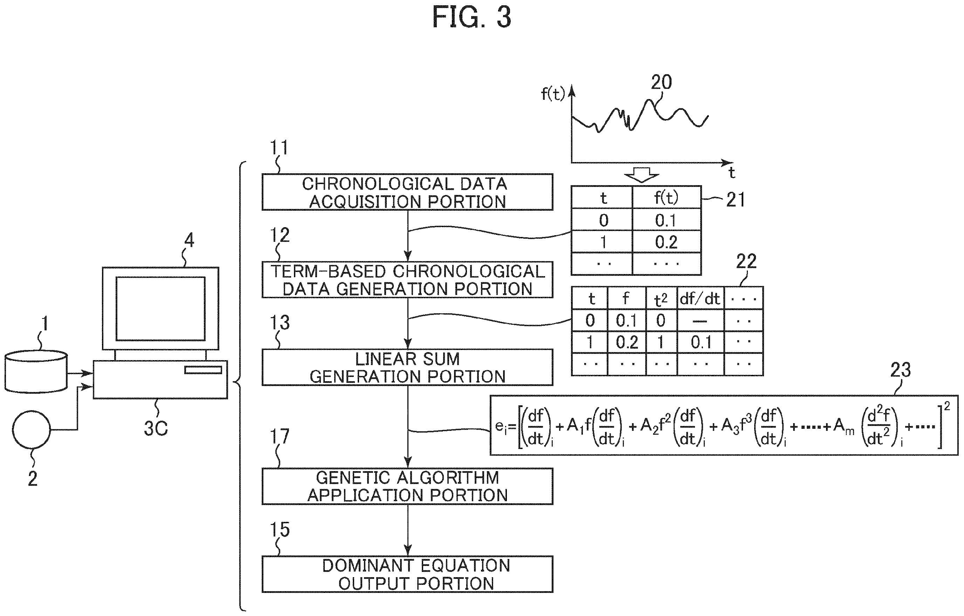

FIG. 3 is a block diagram illustrating a configuration of the data analysis device according to the third embodiment.

In the configuration of FIG. 3, a terminal 3C is provided instead of the terminal 3A in FIG. 1. The terminal 3C includes a genetic algorithm application portion 17 as the coefficient determination portion 14 in FIG. 1. The genetic algorithm application portion 17 provides a plurality of individuals using genes to express candidates for coefficients $A_1$ through $A_m$, preferentially selects individuals indicating high fitness, and searches for coefficient $A_1$ through $A_m$ while repeating operations such as recombination and mutation.

The genetic algorithm is generally performed by the following procedure.

- STEP-A1: Set an appropriate objective function. The present embodiment uses the number of terms of error E in (Equation 5).
- STEP-A2: Prepare two sets called "current generation" and "next generation." Each set includes M individuals (M is an integer greater than or equal to 2).
- STEP-A3: Provide the "current generation" set with an initial value, namely, M individuals as random numbers.
- STEP-A4: Evaluate the fitness of individuals in the "current generation" to the objective function.
- STEP-A5: Perform the following operations (B1) through (B3) with a certain probability and save the results as the "next generation."

    (B1) Replication: Use the gene of a current individual as is.
    (B2) Crossover: Select two individuals and recombine the genes.
    (B3) Mutation: Change the gene of one selected individual.

- STEP-A6: Repeat the operations (B1) through (B3) until the number of generated individuals in the "next generation" reaches M. When the number of individuals reaches M, replace the "next generation" with the new "current generation."
- STEP-A7: Repeat the above operations of "current generation" → "next generation" → "current generation"→ and so on, up to a predetermined value corresponding to the maximum number of households. Find a solution that belongs to the final "current generation" and indicates the highest fitness to the objective function.

The first embodiment relatively compares coefficients $A_1$ through $A_m$ for the terms with each other and deletes a small one of coefficients $A_1$ through $A_m$. However, the use of this genetic algorithm sets the objective function so that error E given by (Equation 5) is minimized and the number of terms in the dominant equation is minimized. Consequently, it is possible to minimize error E and automatically delete a term corresponding to a relatively small coefficient $A_1$ through $A_m$. It is therefore possible to minimize the number of terms included in the dominant equation obtained from chronological data 21 and find a simpler solution.

There may be a case where the value of the coefficient $A_1$ through $A_m$ for the terms is significantly smaller than the other coefficients (for example, 1/100 or less). In such a case, an optimization commercial law other than the genetic algorithm may be used to omit a term related to the coefficient.

When the first to third embodiments are combined, the following algorithm can be used to find a dominant equation behind the chronological data 21.

    (C1) Supply chronological data such as time ($t_0$, $t_1$, $t_2$, $t_3$, ..., $t_N$) and data ($f_0$, $f_1$, $f_2$, $f_3$, ..., $f_N$).
    (C2) From the chronological data, generate terms assumed for dominant equations such as primary differentiation, secondary differentiation, tertiary differentiation, ..., f, and $f^2$ of the chronological data.
    (C3) Use the genetic algorithm to generate a combination of terms assumed from (C2).
    (C4) Assign coefficients $A_1$ through $A_m$ to the terms and use the Gauss-Seidel method to find coefficients $A_1$ through $A_m$.
    (C5) Use the genetic algorithm to find a combination of terms that minimizes a total error.
    (C6) Perform numerical calculation on the differential equation based on the result found from the genetic algorithm and confirm the calculation.

The genetic algorithm is assumed to be general-purpose. The objective function is configured as "minimum error" and "minimum number of terms."

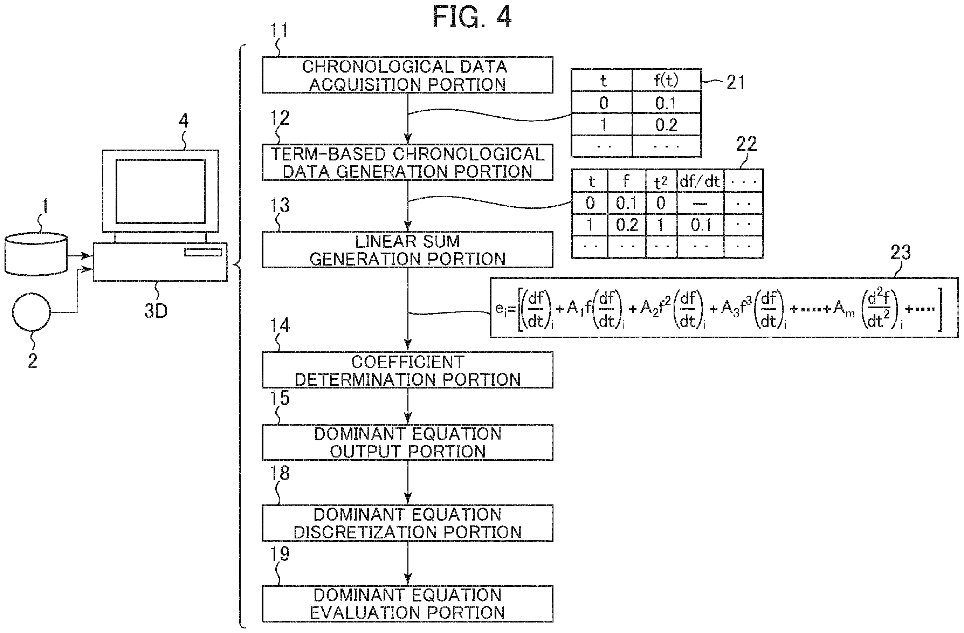

FIG. 4 is a block diagram illustrating a configuration of the data analysis device according to the fourth embodiment.

In the configuration of FIG. 4, a terminal 3D is provided instead of the terminal 3A in FIG. 1. The terminal 3D includes a dominant equation discretization portion 18 and a dominant equation evaluation portion 19 as an addition to the configuration of FIG. 1. The dominant equation discretization portion 18 discretizes a dominant equation output from the dominant equation output portion 15. The dominant equation evaluation portion 19 evaluates the dominant equation based on a result of comparing the solution obtained by discretizing the dominant equation with the chronological data 21.

The description below specifically explains a method of numerically discretizing the dominant equation. In general, a model equation of the dominant equation can be given by the following (Equation 15), where $C_1$, $C_2$, and so on denote constants.

[Equation 15]

$$C_1t + C_2t^2 + \cdots + C_ie^{C_jt} + C_kf + C_lf^2 + \cdots + \left(C_mt + C_nt^2 + \cdots C_pf + \cdots\right)\frac{df}{dx}$$

$$+\left(C_qt + C_rt^2 + \cdots + C_sf + C_tf^2 + \cdots\right)\frac{d^2f}{dx^2} + (C_ut + C_vt^2 + \cdots C_wf + \cdots)\frac{d^3f}{dx^3}$$

$$+\left(C_zt + C_{aa}t^2 + \cdots + C_{ab}f + C_{ac}f^2 + \cdots\right)\frac{d^4f}{dx^4} = e$$

(Equation 15) can be summarized in the following (Equation 16).

[Equation 16]

$$G(t,f) + F_1(t,f)\frac{df}{dx} + F_2(t,f)\frac{d^2f}{dx^2} + F_3(t,f)\frac{d^3f}{dx^3} + F_4(t,f)\frac{d^4f}{dx^4} = e$$

This algorithm determines a constant for each term to minimize the sum of errors e. To verify the validity of the determined terms and constants, it is necessary to solve the differential equation under appropriate initial conditions and compare the result with the chronological data 21.

The solution will be described below.

The following (Equation 17) defines a discretization equation for the primary differentiation at point i of the differentiation. The following (Equation 18) defines a discretization equation for the secondary differentiation at point i of the differentiation.

[Equation 17]

$$\frac{df}{dx} = \frac{f_i - f_{i-1}}{\Delta}$$

[Equation 18]

$$\frac{d^2f}{dx^2} = \frac{f_{i+1} - 2f_i + f_{i-1}}{\Delta^2}$$

The same applies to find discretization equations for tertiary differentiation or higher orders. Based on this, a specific algorithm will be described below.

- STEP-B1: Find the maximum order of the differentiation for the determined terms.
- STEP-B2: Represent error e of (Equation 16) by using the term of the maximum order or lower.

When the differential equation is only the primary differentiation, for example, error e for (Equation 16) is comparable to the following (Equation 19).

[Equation 19]

$$G(t, f) + F_1(t, f)\frac{df}{dx} = e$$

The discretization equation for the primary differentiation of (Equation 17) is substituted into (Equation 19) to obtain the following (Equation 20).

[Equation 20]

$$\frac{df}{dx} = \frac{f_{i+1} - f_i}{\Delta} = \frac{e - G(t, f)}{F_1(t, f)}$$

(Equation 20) is transformed to obtain the following (Equation 21).

[Equation 21]

$$f_{i+1} = f_i + \Delta\frac{e - G(t, f)}{F_1(t, f)}$$

At this time, (Equation 21) can be solved if one initial condition is given. The dominant equation evaluation portion 19 can evaluate the dominant equation by comparing the solution of (Equation 21) with the chronological data 21. The same procedure can be used to solve even higher-order differential equations.

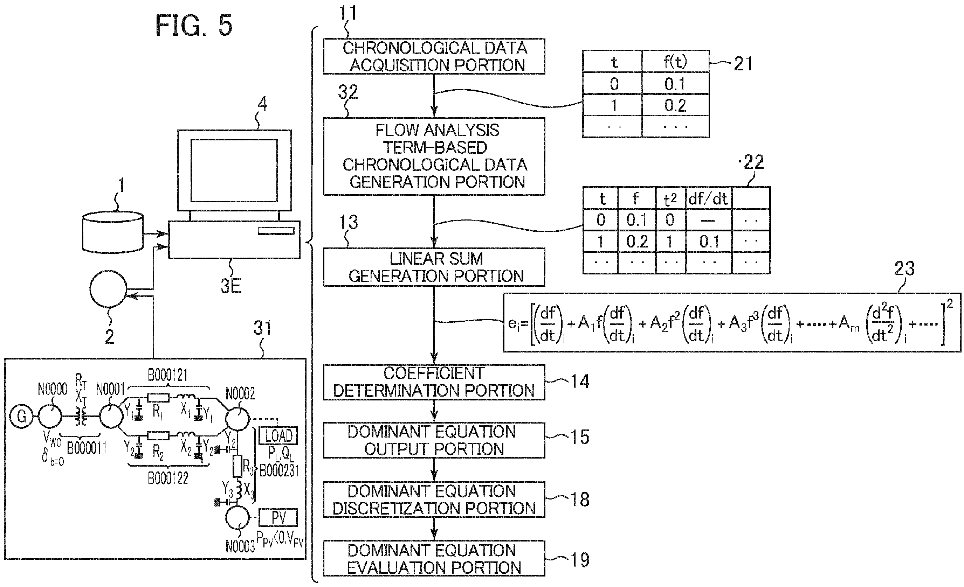

FIG. 5 is a block diagram illustrating a configuration of the power flow analysis device according to the fifth embodiment.

The configuration of FIG. 5 includes a terminal 3E instead of the terminal 3D in FIG. 4. The terminal 3E includes a flow analysis term-based chronological data generation portion 32 as the term-based chronological data generation portion 12 in FIG. 1. Based on the chronological data 21, the flow analysis term-based chronological data generation portion 32 generates term-based chronological data 22 related to load flow equations of the power system.

The chronological data acquisition portion 11 can acquire a schematic diagram 13 of the power system via the external output portion 2. At this time, the chronological data acquisition portion 11 can acquire current values flowing into the system from node i and voltage values of node i from the schematic diagram 13 of the power system.

The following (Equation 22) can generally give a power equation at node i in load flow equations of the power system. The following (Equation 23) can give a current flowing from node i into the system. The dot represents a complex number and the bar represents a complex conjugate.

[Equation 22]

$$P_i + jQ_i = \dot{V}_i\bar{\dot{I}}_i$$

[Equation 23]

$$\dot{I}_i = \sum_{m=0}^{n} \dot{Y}_{im}\dot{V}_m$$

Pi denotes active power (the direction from node i to the system is positive). $Q_i$ denotes reactive power (the direction from node i to the system is positive). Dotted $V_m$ denotes the voltage of line m connected to node i. Dotted $Y_{im}$ denotes the admittance of line m connected to node i. (Equation 22) and (Equation 23) yield the following (Equation 24).

[Equation 24]

$$P_i + jQ_i = \sum_{m=0}^{n} \overline{\dot{Y}}_{im}\dot{V}_i\overline{\dot{V}}_m$$

The chronological data acquisition portion 11 acquires, as the chronological data 21, a current value and a voltage value of node i flowing into the system from node i at each time t. The flow analysis term-based chronological data generation portion 32 assumes the current value and the voltage value of node i flowing from node i into the system at each time t to be the chronological data 22 for each term.

Then, the linear sum generation portion 13 converts (Equation 24) into a positive value and substitutes the current value and the voltage value of node i, flowing from the node i into the system, into (Equation 24) to find error ei. Then, the coefficient determination portion 14 determines the admittance of each line m so that the sum of errors ei acquired in the linear sum generation portion 13 becomes smaller than or equal to a predetermined value or approaches 0.

Unlike the first to fourth embodiments, the fifth embodiment previously provides the load flow equation of the power system. The dominant equation output portion 15 outputs a coefficient calculated in the coefficient determination portion 14 as a value of the admittance of each line m. Normally, in power flow calculation, the system supplies the admittance as known information. However, it is often difficult to obtain detailed values thereof. If the power flow in each node i is given, the fifth embodiment can automatically determine the admittance of each line in the schematic diagram 31 of the power system and automatically generate an impedance map of each line essential to the system analysis.

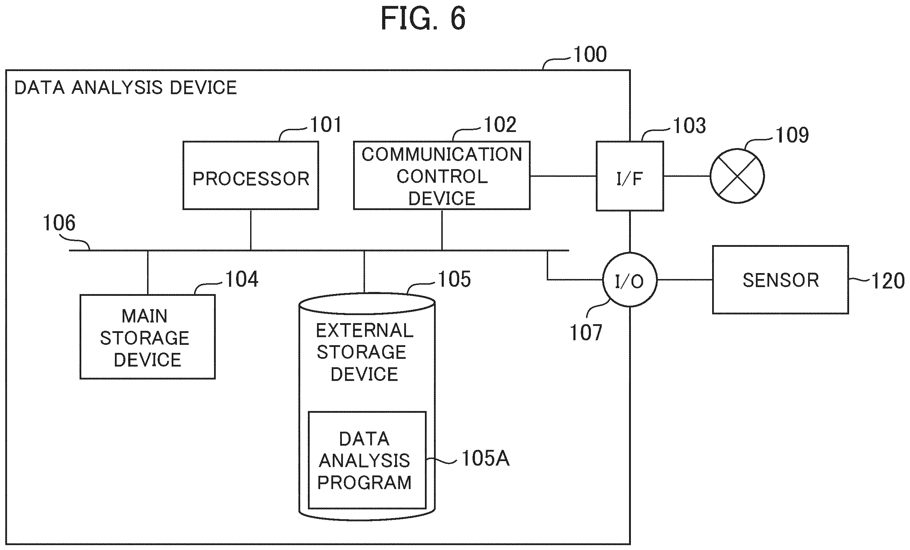

FIG. 6 is a block diagram illustrating a hardware configuration applicable to the data analysis device according to the sixth embodiment.

In FIG. 6, a data analysis device 100 includes a processor 101, a communication control device 102, a communication interface 103, a main storage device 104, and an external storage device 105. The processor 101, the communication control device 102, the communication interface 103, the main storage device 104, and the external storage device 105 are mutually connected via an internal bus 106. The main storage device 104 and the external storage device 105 are accessible from the processor 101.

A sensor 120 is provided outside the data analysis device 100. The sensor 120 is connected to the internal bus 106 via an input/output interface 107.

The processor 101 is hardware that controls the entire operation of the data analysis device 100. The main storage device 104 can be composed of semiconductor memory such as SRAM or DRAM, for example. The main storage device 104 can store a program being executed by the processor 101 or can include a work area for the processor 101 to execute the program.

The external storage device 105 is a storage device having a large storage capacity and represents a hard disk device or an SSD (Solid State Drive), for example. The external storage device 105 can store executable files of various programs and data used for executing the programs. The external storage device 105 can store a data analysis program 105A. The data analysis program 105A may represent software installable in the data analysis device 100 or may be built as firmware in the data analysis device 100.

The communication control device 102 is hardware having a function of controlling communication with the outside. The communication control device 102 is connected to a network 109 via the communication interface 103. The network 109 may represent a WAN (Wide Area Network) such as the Internet, a LAN (Local Area Network) such as WiFi, or a mix of WAN and LAN.

The input/output interface 107 converts sensor data input from the sensor 120 into a data format the processor 101 can process. The input/output interface 107 may include an AD converter.

The data analysis device 100 can acquire the chronological data 21 from the network 109 or the sensor 120 and store the chronological data 21 in the external storage device 105. The processor 101 reads the data analysis program 105A into the main storage device 104 and executes the data analysis program 105A, making it possible to find a dominant equation behind the chronological data 21.

At this time, the data analysis program 105A can implement the functions of the term-based chronological data generation portion 12, the linear sum generation portion 13, the coefficient determination portion 14, and the dominant equation output portion 15 in FIG. 1.

A plurality of processors or computers may share the execution of the data analysis program 105A. Alternatively, the processor 101 may instruct a cloud computer, for example, via the network 109 to execute all or part of the data analysis program 105A and receive the execution result.

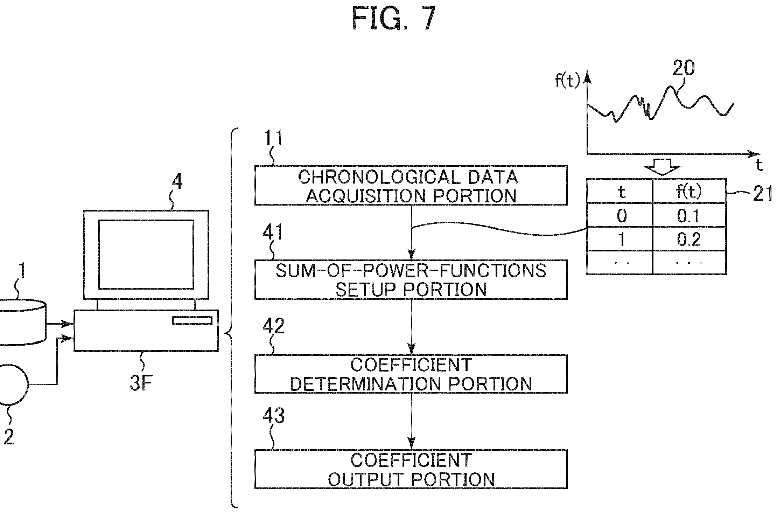

FIG. 7 is a block diagram illustrating a configuration of the data analysis device according to a comparative example.

The configuration of FIG. 7 includes a terminal 3F instead of the terminal 3A in FIG. 1. The terminal 3F includes the chronological data acquisition portion 11, a sum-of-power-functions setup portion 41, a coefficient determination portion 42, and a coefficient output portion 43. The sum-of-power-functions setup portion 41 sets the sum of power functions at time t. The sum of power functions expresses chronological data 21 based on the approximate function using the power function. This sum of power functions can be given by the following (Equation 25), where the coefficients are $A_i$, $C_i$, and so on.

[Equation 25]

$$f(t) = \sum_{i=0}^{N} A_i t^{C_i}$$

The coefficient determination portion 42 obtains coefficients $A_i$, $C_i$, and so on to minimize a difference between the sum of linear power functions and the chronological data 21. At this time, the coefficient determination portion 42 can use a genetic algorithm. The coefficient output portion 43 outputs coefficients $A_i$, $C_i$, and so on obtained by the coefficient determination portion 42. The sum of linear power functions expresses chronological data 21 based on the approximate function using the power function and differs from a dominant equation behind the chronological data 21.

List of Reference Signs

1 data storage medium, 2 external output portion, 3A through 3E terminal, 4 display portion, 11 chronological data acquisition portion, 12 term-based chronological data generation portion, 13 linear sum generation portion, 14 coefficient determination portion, 15 dominant equation output portion

**Claims**

1. A data analysis device comprising:

    a term-based chronological data generation portion that, based on input chronological data, generates term-based chronological data including a differential term assumed to be a term of a dominant equation for the input chronological data;
    a linear sum generation portion that generates a positive value of the linear sum of products of each term and a coefficient at each time of the input chronological data; and
    a coefficient determination portion that determines the coefficient of each term so that the sum of positive values of the linear sum in one of a time segment and a space segment targeted by the chronological data becomes smaller than or equal to a predetermined value or approaches 0.

2. The data analysis device according to claim 1, further comprising:

a dominant equation output portion that outputs, as a dominant equation for the input chronological data, the linear sum of products of the coefficient determined by the coefficient determination portion and each term.

**3.** The data analysis device according to claim 1,
wherein the term includes one of a differential term with respect to time or space, a power term of time, space, or physical quantity, a functional term of time, space, or physical quantity, and a product term acquired by mutually multiplying the terms.

**4.** The data analysis device according to claim 1,
wherein a positive value of the linear sum represents one of a square value and an absolute value of the linear sum.

**5.** The data analysis device according to claim 1,
wherein the coefficient determination portion determines a coefficient of each term based on the Gauss-Seidel method.

**6.** The data analysis device according to claim 1,
wherein the coefficient determination portion omits a term having a coefficient smaller than a predetermined value in comparison with coefficients of other terms.

**7.** The data analysis device according to claim 6,
wherein the coefficient determination portion determines a coefficient of each term based on a genetic algorithm.

**8.** The data analysis device according to claim 1, further comprising:
a dominant equation evaluation portion that evaluates the dominant equation based on a result of comparing a solution obtained by discretizing the dominant equation and the input chronological data.

**9.** A power flow analysis device comprising:

a term-based chronological data generation portion that, based on input chronological data, generates term-based chronological data related to a load flow equation for a power system;
a linear sum generation portion that generates a positive value of the linear sum of products of each term and a coefficient at predetermined times of the input chronological data; and
a coefficient determination portion that determines the coefficient of each term so that the sum of positive values of the linear sum in one of a time segment and a space segment targeted by the chronological data becomes smaller than or equal to a predetermined value or approaches 0.

**10.** The power flow analysis device according to claim 9,
wherein an impedance map of each line of the power system is generated based on a coefficient of each term related to the load flow equation.

**11.** A data analysis method comprising:

determining a coefficient of each term of a differential equation so that the differential equation reproduces input chronological data; and
outputting the differential equation represented by the determined coefficient as a dominant equation for the input chronological data.

**12.** The data analysis method according to claim 11 comprising:

generating term-based chronological data for the differential equation based on the input chronological data;
generating a positive value of the linear sum of products of each term and a coefficient of the differential equation at predetermined times of the input chronological data; and
determines the coefficient of each term so that the sum of positive values of the linear sum in one of a time segment and a space segment targeted by the chronological data becomes smaller than or equal to a predetermined value or approaches 0.

**13.** The data analysis method according to claim 11,
wherein a term of the dominant equation includes one of a differential term with respect to time or space, a power term of time, space, or physical quantity, a functional term of time, space, or physical quantity, and a product term acquired by mutually multiplying the terms.

EP 3 792 786 A1

# FIG. 1

f(t)

20

11 — CHRONOLOGICAL DATA ACQUISITION PORTION

| t | f(t) | 21 |
|---|------|----|
| 0 | 0.1 | |
| 1 | 0.2 | |
| .. | ... | |

12 — TERM-BASED CHRONOLOGICAL DATA GENERATION PORTION

| t | f | $t^2$ | df/dt | ... |
|---|-----|-------|-------|-----|
| 0 | 0.1 | 0 | — | .. |
| 1 | 0.2 | 1 | 0.1 | .. |
| .. | ... | . | ... | .. |

22

13 — LINEAR SUM GENERATION PORTION

23

$$e_i = \left[ \left(\frac{df}{dt}\right)_i + A_1 f\left(\frac{df}{dt}\right)_i + A_2 f^2\left(\frac{df}{dt}\right)_i + A_3 f^3\left(\frac{df}{dt}\right)_i + \cdots + A_m \left(\frac{d^2 f}{dt^2}\right)_i + \cdots \right]^2$$

14 — COEFFICIENT DETERMINATION PORTION

15 — DOMINANT EQUATION OUTPUT PORTION

4

1

2

3A

# FIG. 2

# FIG. 3

EP 3 792 786 A1

11 CHRONOLOGICAL DATA ACQUISITION PORTION

| t | f(t) | ~21 |
|---|---|---|
| 0 | 0.1 | |
| 1 | 0.2 | |
| .. | ... | |

12 TERM-BASED CHRONOLOGICAL DATA GENERATION PORTION

| t | f | $t^2$ | df/dt | ··· | 22 |
|---|---|---|---|---|---|
| 0 | 0.1 | 0 | — | ·· | |
| 1 | 0.2 | 1 | 0.1 | ·· | |
| .. | .. | .. | .. | ·· | |

13 LINEAR SUM GENERATION PORTION

23

$$e_i = \left[ \left(\frac{df}{dt}\right)_i + A_1 f \left(\frac{df}{dt}\right)_i + A_2 f^2 \left(\frac{df}{dt}\right)_i + A_3 f^3 \left(\frac{df}{dt}\right)_i + \cdots + A_m \left(\frac{d^2 f}{dt^2}\right)_i + \cdots \right]^2$$

17 GENETIC ALGORITHM APPLICATION PORTION

15 DOMINANT EQUATION OUTPUT PORTION

20
f(t)
t

4

1

2

3C

# FIG. 4

CHRONOLOGICAL DATA ACQUISITION PORTION — 11

TERM-BASED CHRONOLOGICAL DATA GENERATION PORTION — 12

LINEAR SUM GENERATION PORTION — 13

COEFFICIENT DETERMINATION PORTION — 14

DOMINANT EQUATION OUTPUT PORTION — 15

DOMINANT EQUATION DISCRETIZATION PORTION — 18

DOMINANT EQUATION EVALUATION PORTION — 19

Table 21:

| t | f(t) |
|---|------|
| 0 | 0.1 |
| 1 | 0.2 |
| .. | ... |

Table 22:

| t | f | $t^2$ | df/dt | ... |
|---|---|-------|-------|-----|
| 0 | 0.1 | 0 | — | .. |
| 1 | 0.2 | 1 | 0.1 | .. |
| .. | .. | .. | .. | .. |

Equation 23:

$$e_i = \left[ \left(\frac{df}{dt}\right)_i + A_1 f\left(\frac{df}{dt}\right)_i + A_2 f^2\left(\frac{df}{dt}\right)_i + A_3 f^3\left(\frac{df}{dt}\right)_i + \cdots + A_m \left(\frac{d^2 f}{dt^2}\right)_i + \cdots \right]$$

EP 3 792 786 A1

FIG. 5

11 — CHRONOLOGICAL DATA ACQUISITION PORTION

| t | f(t) | — 21 |
|---|------|---|
| 0 | 0.1 | |
| 1 | 0.2 | |
| .. | ... | |

32 — FLOW ANALYSIS TERM-BASED CHRONOLOGICAL DATA GENERATION PORTION

·22

| t | f | $t^2$ | df/dt | |
|---|-----|-----|------|----|
| 0 | 0.1 | 0 | — | .. |
| 1 | 0.2 | 1 | 0.1 | .. |
| .. | .. | .. | .. | .. |

13 — LINEAR SUM GENERATION PORTION

23

$$e_i = \left[\left(\frac{df}{dt}\right)_i + A_1 f\left(\frac{df}{dt}\right)_i + A_2 f^2\left(\frac{df}{dt}\right)_i + A_3 f^3\left(\frac{df}{dt}\right)_i + \cdots + A_m\left(\frac{d^2f}{dt^2}\right)_i + \cdots\right]^2$$

COEFFICIENT DETERMINATION PORTION — 14

DOMINANT EQUATION OUTPUT PORTION — 15

DOMINANT EQUATION DISCRETIZATION PORTION — 18

DOMINANT EQUATION EVALUATION PORTION — 19

4

1

2

3E

31

N0000  $R_T$  $X_T$  N0001  B000121  N0002
G  $V_{WO}$  B000011  $Y_1$ $R_1$ $X_1$ $Y_1$  LOAD $P_L,Q_L$
$\delta_{b=0}$  $Y_2$ $R_2$ $X_2$ $Y_2$  $R_3$ B000231
B000122  $Y_3$ $X_3$
PV
N0003  $P_{PV}<0,V_{PV}$

18

FIG. 6

# FIG. 7

EP 3 792 786 A1

<div align="center">

**INTERNATIONAL SEARCH REPORT**

</div>

| | International application No. |
|---|---|
| | PCT/JP2018/017752 |

| A. CLASSIFICATION OF SUBJECT MATTER |
|---|
| Int. Cl. G06F17/10(2006.01)i |
| According to International Patent Classification (IPC) or to both national classification and IPC |

| B. FIELDS SEARCHED |
|---|
| Minimum documentation searched (classification system followed by classification symbols) |
| Int. Cl. G06F17/10 |
| Documentation searched other than minimum documentation to the extent that such documents are included in the fields searched |
| Published examined utility model applications of Japan   1922-1996<br>Published unexamined utility model applications of Japan   1971-2018<br>Registered utility model specifications of Japan   1996-2018<br>Published registered utility model applications of Japan   1994-2018 |
| Electronic data base consulted during the international search (name of data base and, where practicable, search terms used) |

| C. DOCUMENTS CONSIDERED TO BE RELEVANT | | |
|---|---|---|
| Category* | Citation of document, with indication, where appropriate, of the relevant passages | Relevant to claim No. |
| X<br>Y<br>A | 中野直人ほか，時系列データに対する確率微分方程式モデルの統計的係数決定公式と軌道の予測可能性について，数理解析研究所講究録, [online], September 2014 [retrieved: 26 July 2018], Internet: <URL: http://hdl.handle.net/2433/223373>, no. 1919, pp. 38-60, non-official translation (NAKANO, Naoto et al. Statistical Coefficient Determination Formula and Trajectory Predictability of Stochastic Differential Equation Models for Time Series Data. RIMS Kokyuroku.) | 11<br>13<br>1-10, 12 |
| Y | WO 2018/012487 A1 (NATIONAL UNIVERSITY CORPORATION KUMAMOTO UNIVERSITY) 18 January 2018, paragraphs [0026]-[0034] (Family: none) | 13 |

☒ Further documents are listed in the continuation of Box C. ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 27.07.2018 | 07.08.2018 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.

PCT/JP2018/017752

C (Continuation).    DOCUMENTS CONSIDERED TO BE RELEVANT

| Category* | Citation of document, with indication, where appropriate, of the relevant passages | Relevant to claim No. |
|---|---|---|
| A | WO 2014/141344 A1 (NEC CORP.) 18 September 2014, abstract & US 2016/0042101 A1 | 1-13 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ABDULRAHMAN BAQAIS.** Generic Algorithm for function approximation: An experimental investigation. *International Journal of Artificial Intelligence and Applications (IJAIA),* May 2016, vol. 7 (3